# EUROPEAN PATENT APPLICATION

(11) **EP 0 923 124 A2**
(43) Date of publication of application: **16.06.1999**
(21) Application number: 98309664.5
(22) Date of filing: 25.11.1998
(51) Int. Cl.: H01L 21/768, H01L 23/532

(54) **A method and system of interconnecting conductors in an integrated circuit**

(30) Priority: 26.11.1997 US 66961 P
(71) Applicant: TEXAS INSTRUMENTS INCORPORATED, Dallas, TX 75265 (US)
(72) Inventor: Fukuhara, Hideyuki, Kodaira City, Tokyo 18 (JP); Ashigaki, Shigeo, Richardson, TX 75080 (US)
(74) Representative: Holt, Michael

(57) **Abstract**

The method and system of interconnecting conductors in an integrated circuit may include providing a lower conductor (12) disposed in an insulation layer (14). A through hole (34) may be formed in the insulation layer (14) substantially aligned over the lower conductor (12) to expose a section (36) of the lower conductor (12). A misalignment insulation layer (42) may be formed outwardly of a bottom (44) of the through hole (34). At least a portion of the misalignment insulation layer (42) may be removed to expose at least a part (50) of the section (36) of the lower conductor (12). An interconnect (60) may then be formed in the through hole (34) and connected to the lower conductor (12).

## Description

### TECHNICAL FIELD OF THE INVENTION

This invention relates generally to the field of semiconductor devices, and more particularly to a method and system of interconnecting conductors in an integrated circuit.

### BACKGROUND OF THE INVENTION

Modern electronic equipment such as televisions, telephones, radios and computers are often constructed of solid state devices. Solid state devices operate based on the movement of charged carriers. Accordingly, solid state devices have no moving parts.

Solid state devices are generally preferred in electronic equipment because they are extremely reliable, very small and relatively inexpensive. Solid state devices may be transistors, capacitors, resistors, and the like. Such devices are often formed as part of an integrated circuit.

In an integrated circuit, an interconnect between different conductive layers is often formed in a through hole. To prevent alignment and processing fluctuations from causing part of the through hole to step off a lower layer conductor and reach an under lower layer conductor, the lower conductive layer typically includes an overlap margin. The overlap margin is an enlarged section of the lower conductor that absorbs alignment and processing fluctuations. As a result, the interconnect does not extend to the under lower layer conductor and yield an electrical short.

The overlap margin, however, is disadvantageous in that it requires extra area within an integrated circuit. The extra area prevents the size of the integrated circuit from being minimized which is increasingly important to reduce the size of electronic equipment.

### SUMMARY OF THE INVENTION

Accordingly, a need has arisen in the art for an improved method and system for interconnecting conductors in an integrated circuit. The present invention provides a method and system that substantially eliminate and reduce problems associated with prior interconnection methods and systems.

In accordance therewith, conductors of an integrated circuit may be interconnected by providing a lower conductor disposed in an insulation layer. A through hole may be formed in the insulation layer substantially aligned over the lower conductor to expose a section of the lower conductor. A misalignment insulation layer may be formed outwardly of a bottom of the through hole. At least a portion of the misalignment insulation layer may be removed to expose at least a part of the section of the lower conductor. An interconnect may then be formed in the through hole and connected to the lower conductor.

More specifically, in accordance with one embodiment, an upper conductor may be formed outwardly of the insulation layer and connected to the interconnect. In this and other embodiments, an under lower conductor may be provided inwardly of the lower conductor and separated from the lower conductor by the insulation layer. The through hole may comprise a misaligned section exposing a section of the under lower conductor. The misalignment insulation layer may remain in at least part of the misaligned section to insulate the lower conductor from the under lower conductor.

In a particular embodiment, a through hole may be formed by forming a photo resist layer outwardly of the insulation layer. An opening may be patterned in the photo resist layer substantially aligned with the lower conductor. The through hole may be etched in the insulation layer through the opening in the photo resist layer to expose the section of the lower conductor. In this and other embodiments, the misalignment insulation layer may be formed by depositing an insulator outwardly of the bottom of the through hole.

Important technical advantages disclosed herein include providing an improved integrated circuit. In particular, the integrated circuits may include substantially uniform conductors without enlarged overlap margins. Accordingly, the size of the conductors and the material needed to form the conductors may be reduced. The size of the integrated circuit layout may be correspondingly reduced.

Another technical advantage of the disclosed teachings includes providing an improved method and system of interconnecting conductors in an integrated circuit. In particular, a misalignment insulation layer may be formed in a misaligned section of a through hole. Accordingly, electrical shorts caused by an interconnect formed in a through hole having a misaligned section are substantially reduced or eliminated.

Other technical advantages will be readily apparent to one skilled in the art from the following figures, descriptions and claims.

### BRIEF DESCRIPTION OF THE DRAWINGS

For a more complete understanding the present invention and its advantages thereof, references now made to the following description taken in conjunction with the accompanying drawings, wherein like reference numerals represent like parts, in which:

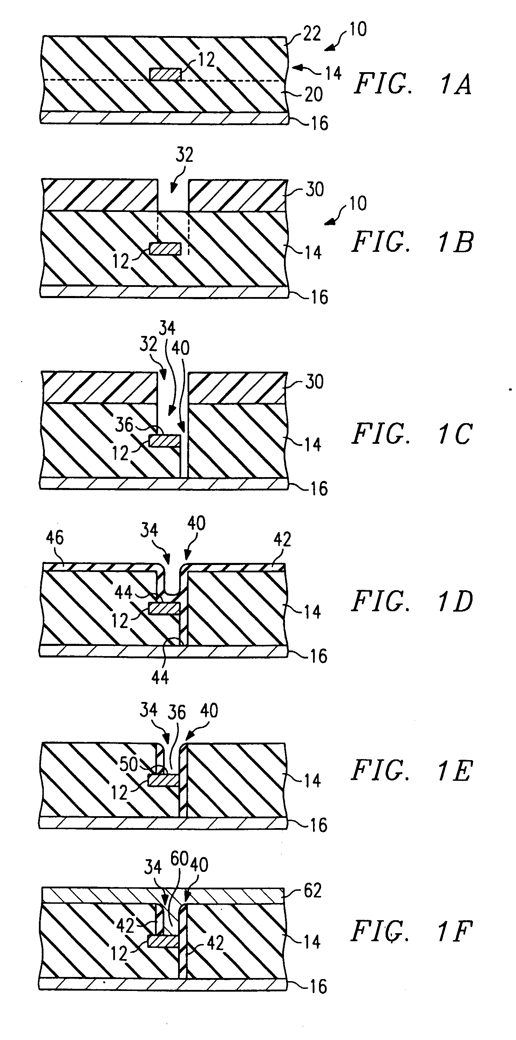

FIGURES 1A-F are a series of schematic cross-sectional diagrams illustrating a method and system of interconnecting conductors in an integrated circuit in accordance with the one embodiment of the disclosed teachings.

### DETAILED DESCRIPTION OF THE INVENTION

The preferred embodiment of the teachings disclosed herein and its advantages are best understood by referring now in more detail to FIGURES 1A-F of the drawings, in which like numerals refer to like parts throughout the several views. FIGURES 1A-F illustrate a method and system of interconnecting conductors in an integrated circuit. As described in more detail below, an interconnect may be formed in a through hole between conductors. The through hole may include a misalignment insulation layer formed in a misaligned section of the through hole to prevent the interconnect from electrically shorting to another conductor. Accordingly, a lower conductor need not include an enlarged overlap margins to prevent misalignments and shorting. As a result, the size of the conductors and the material needed to form the conductors may be reduced. The size of the integrated circuit may be correspondingly reduced.

FIGURE 1A illustrates an initial semiconductor structure 10 of an integrated circuit. In this embodiment, the initial semiconductor structure 10 may comprise a lower conductor 12 disposed in an insulation layer 14. An under lower conductor 16 may be disposed inwardly of the lower conductor 12 and separated from the lower conductor 12 by the insulation layer 14. It will be understood that the lower conductor 12 and the under lower conductor 16 may be otherwise disposed with respect to one another or the insulation layer 14. Thus, the lower and under lower conductors 12 and 16 may be any first and second conductors in an integrated circuit. It will be further understood that the initial semiconductor structure 10 may be otherwise configured or comprise other elements without departing from the scope of the disclosed teachings.

In one embodiment, the initial semiconductor structure 10 may be provided by forming the under lower conductor 16 on an insulator layer or other element (not shown) of an integrated circuit. In a particular embodiment, the under lower conductor 16 may comprise a metal such as titanium, tungsten, copper, aluminum, an alloy and the like. In this and other embodiments the under lower conductor 16 may be formed by deposition, plating and other conventional integrated circuit processing techniques. It will be understood that the under lower conductor 16 may comprise other materials capable of conducting a signal.

A first insulation sub layer 20 of the insulation layer 14 may be formed outwardly of the under lower conductor 16. In a particular embodiment, the first insulation sub layer 20 may comprise an insulator such as silicon dioxide and the like. In this and other embodiments, the first insulation sub layer 20 may be formed by deposition and other conventional integrated circuit processing techniques. It will be understood that the first insulation sub layer 20 may comprise other materials capable of insulating a conductor.

The lower conductor 12 may be formed outwardly of the first insulation sub layer 20. In a particular embodiment, the lower conductor 12 may comprise a metal such as titanium, tungsten, copper, aluminum, an alloy and the like. In this and other embodiments, the lower conductor 12 may be formed by deposition, plating and other conventional integrating circuit processing techniques. It will be understood that the lower conductor 12 may comprise other materials capable of conducting a signal.

A second insulation sub layer 22 of the insulation layer 14 may be formed outwardly of the first insulation sub layer 20 and the lower conductor 12. The first and second insulation sub layers may together form the insulation layer 14 to insulate the lower conductor 12. In a particular embodiment, the second insulation sub layer 22 may comprise an insulator such as silicon dioxide and the like. In this and other embodiments the second insulation sub layer 22 may be formed by deposition and other conventional integrated circuit processing techniques. It will be understood that the second insulation sub layer 22 may comprise other materials capable of insulating a conductor. It will be further understood that the initial semiconductor structure 10 may be otherwise formed or provided.

Referring to FIGURE 1B, a photo resist layer 30 may be formed outwardly of the insulation layer 14. In one embodiment, the photo resist layer 30 may be deposited onto the insulation layer 14 in accordance with conventional integrated circuit processing techniques. It will be understood that the photo resist layer 30 may be otherwise formed outwardly of the insulation layer 14.

The photo resist layer 30 may be patterned and etched to form an opening 32 in the photo resist layer 30. The photo resist layer 30 may be patterned and etched in accordance with conventional integrated circuit processing techniques. It will be understood that the opening 32 may be otherwise formed without departing from the disclosed teachings.

The opening 32 may be substantially aligned with the lower conductor 12. The opening 32 is substantially aligned with the lower conductor 12 when at least part of the opening 32 is disposed over at least part of the lower conductor 12. Alignment of the opening 32 with the lower conductor 12 may vary depending on process and alignment fluctuations. Preferably, a maximum part of the opening 32 is disposed over a maximum part of the lower conductor 12 to maximize the connection between an interconnect and the lower conductor 12. It will be understood that the opening 32 may be otherwise substantially aligned with the lower conductor 12.

Referring to FIGURE 1C, a through hole 34 may be formed in insulation layer 14 through the opening 32 in the photo resist layer 30. The through hole 34 may expose a section 36 of the lower conductor 12. In embodiment, the through hole 34 may be formed by anisotropically etching the insulation layer 14 in accordance with conventional integrated circuit processing techniques. It will be understood that the through hole 34 may be otherwise formed. For example, the through hole 34 may be formed by a plasma etch or the like.

Processing and alignment fluctuations in forming the opening 32 or the through hole 34 may result in a misaligned section 40 of the through hole 34. The misaligned section 40 may be the section of the through hole 34 that is not over the lower conductor 12. In one embodiment where the conductors 12 and 16 act as an etch stop during formation of the through hole 34, the through hole 34 may generally extend to the lower conductor 12 with the misaligned section 40 further extending to the under lower conductor 16. It will be understood that the misaligned section 40 may be otherwise disposed, formed or not formed without departing from the through hole 34 in the scope of the disclosed teachings.

Referring to FIGURE 1D, the photo resist layer 30 may be removed from the insulation layer 14 after formation of the through hole 34. The photo resist layer 30 may be removed in accordance with conventional integrated circuit processing techniques. It will be understood that the photo resist layer 30 may be otherwise removed.

A misalignment insulation layer 42 may be formed at least in part in the misaligned section 40 of the through hole 34. In one embodiment, the misalignment insulation layer 42 may be formed between the lower conductor 12 and the under lower conductor 16 to prevent an interconnect formed in the through hole 34 from extending and shorting to the under lower conductor 16. It will be understood that the misalignment insulation layer 42 may be otherwise disposed in the misaligned section 40.

In a particular embodiment, the misalignment insulation layer 42 may be formed outwardly of a bottom 44 of the through hole 34. In this embodiment, the misalignment insulation layer 42 may comprise silicon dioxide deposited across a top of the insulation layer 14 and the bottom 44 of the through hole 34. The silicon dioxide may be deposited by chemical vapor deposition (CVD) in accordance with conventional integrated circuit processing techniques. It will be understood that the misalignment insulation layer 42 may comprise other materials or be otherwise formed. For example, the misalignment insulation layer 42 may comprise O₃/TEOS oxide deposited at atmospheric pressure, a bias plasma ECR oxide, and the like.

Preferably, the misalignment insulation layer 42 is deposited to an average depth 46 sufficient to substantially fill the misaligned section 40 of the through hole 34 between the lower conductor 14 and the under lower conductor 16. Thus, the average depth 46 of the misalignment insulation layer 42 may vary depending on the size and configuration of the misalignment section 40 including the depth of the misalignment section 40 between lower conductor 12 and the under lower conductor 16.

Referring to FIGURE lE, in the embodiment where the misalignment insulation layer 42 is formed across the bottom 44 of the through hole 34, at least a portion of the misalignment insulation layer 42 may be removed to expose at least a part 50 of the initially exposed section 36 of the lower conductor 12. In this embodiment, the portion of the misalignment insulation layer 42 may be removed by anisotropically the misalignment insulation layer 42 in accordance with conventional integrated circuit etch/back techniques. It will be understood that the portion of the misalignment insulation layer 42 may be otherwise removed.

In a particular embodiment, about 10%-20% of the misalignment insulation layer 42 may be removed to expose at least the part 50 of the initially exposed section 36 of the lower conductor 12. In this embodiment, the misalignment insulation layer 42 may remain on sidewalls of the through hole 34 and in at least part of the misaligned section 40 between the lower conductor 12 and the under lower conductor 16. It will be understood that remaining portions of the misalignment insulation layer 42 may be otherwise disposed in the through hole 34 and the misalignment section 40.

Referring to FIGURE 1F, an interconnect 60 may be formed in the through hole 34 and connected to the lower conductor 12. In one embodiment, an interconnect 60 may be formed as part of an upper conductor 62. In this and other embodiments, the interconnect 60 may connect the upper and lower conductors 62 and 12 as required by an integrated circuit layout. It will be understood that the upper and lower conductors 62 and 12 may be otherwise connected.

In a particular embodiment, the upper conductor 62 and the interconnect 60 may comprise a metal such as titanium, tungsten, copper, aluminum, an alloy and the like. In this and other embodiments the upper connector 62 and interconnect 60 may be formed by deposition, plating and other conventional integrated circuit techniques. It will be understood that the upper connector 62 or interconnect 60 may comprise other materials capable of conducting a signal or be otherwise formed.

The interconnect 60 may interconnect the lower conductor 12 and the upper conductor 62 but be insulated from the under lower conductor 16 by the misalignment insulation layer 42 disposed in the misaligned section 40 of the through hole 34. Accordingly, the interconnect 60 will not short to the under lower conductor 16 through the misalignment section 40 of the through hole 34. As a result, the width of the lower conductor 12 may be substantially uniform at least approximate to the through hole 34. Thus, the size of the conductors and the material needed to form the conductors may be reduced. The size of the integrated circuit layout may be correspondingly reduced.

Although the present invention has been described with several exemplary embodiments, various changes and modifications may be suggested to one skilled in the art.

## Claims

1. A method of interconnecting conductors in an integrated circuit, comprising the steps of:
providing a lower conductor disposed in an insulation layer;
forming a through hole in the insulation layer substantially aligned over the lower conductor to expose a portion of the lower conductor;
forming a misalignment insulator layer outwardly of a lower region of the through hole;
removing at least a portion of the misalignment insulation layer to expose at least a part of the portion of the lower conductor; and
forming an interconnect in the through hole connected to the lower conductor.

2. The method of Claim 1, wherein the step of providing the lower conductor disposed in an insulation layer further comprises the steps of:
forming a first insulation sub layer;
forming the lower conductor outwardly of the first insulation sub layer; and
forming a second insulation sub layer outwardly of the first insulation sub layer and the lower conductor, the first and second insulation sub layers forming the insulation layer comprising the lower conductor.

3. The method of Claim 1 or Claim 2, wherein the step of providing the lower conductor comprises providing a lower conductor having a substantially uniform width at least proximate to the through hole.

4. The method of any of Claims 1 to 3, wherein the step of forming the through hole comprises forming a through hole comprises a misaligned portion not over the lower conductor and the misalignment insulation layer remains in at least part of the misaligned portion.

5. The method of any of Claims 1 to 4, further comprising the step of providing an under lower conductor inwardly of the lower conductor and separated from the lower conductor by the insulation layer, wherein the through hole comprises a misaligned portion exposing a portion of the under lower conductor and the misalignment insulation layer remains in at least part of the misaligned portion to insulate the lower conductor from the under lower conductor.

6. The method of any of Claims 1 to 5, wherein the step of providing the lower conductor comprises providing a lower conductor a metal.

7. The method of Claim 5 or Claim 6, wherein the step of providing the under lower conductor comprises providing an under lower conductor comprising a metal.

8. The method of any of Claim 1 to 7, further comprising the step of forming an upper conductor outwardly of the insulation layer and connected to the interconnect.

9. The method of Claim 8, wherein the step of forming an upper conductor comprises forming an upper conductor comprising a metal.

10. The method of any of Claims 1 to 9 wherein, the step of forming the misalignment insulation layer outwardly of the lower region of the through hole comprises depositing silicon dioxide outwardly of the lower region of the through hole.

11. The method of any of Claims 1 to 10 wherein, the step of forming the through hole comprises the steps of:
forming a photo resist layer outwardly of the insulation layer;
patterning an opening in the photo resist layer substantially aligned with the lower conductor; and
etching the through hole in the insulation layer through the opening in the photo resist layer to expose the portion of the lower conductor.

12. A method of interconnecting conductors in an integrated circuit, comprising the steps of:
providing a lower conductor disposed in an insulation layer;
forming a through hole in the insulation layer substantially aligned over the lower conductor to expose a portion of the lower conductor, the through hole including a misaligned section not over the lower conductor
forming a misalignment insulation layer in at least part of the misaligned portion of the through hole; and
forming an interconnect in the through hole connected to the lower conductor.

13. The method of Claim 12, wherein the step of providing the lower conductor comprises providing a lower conductor having a substantially uniform width proximate to the through hole.

14. The method of Claim 12 or Claim 13, further comprising the step of providing an under lower conductor inwardly of the lower conductor and separated from the lower conductor by the insulation layer, wherein the misaligned portion of the through hole exposes a portion of the under lower conductor and at least part of the misalignment insulation layer is formed between the lower conductor and the under lower conductor.

15. The method of any of Claims 12 to 14, wherein the step of providing the lower conductor comprises providing a lower conductor comprising a metal.

16. The method of Claim 14 or Claim 15, wherein the step of providing the under lower conductor comprises providing an under lower conductor comprising a metal.

17. The method of any of Claims 12 to 16, further comprising the step of forming an upper conductor outwardly of the insulation layer and connected to the interconnect.

18. The method of Claim 17, wherein the step of forming the upper conductor comprises forming an upper conductor comprising a metal.

19. The method of any of Claims 12 to 18 wherein the step of forming the misalignment insulation layer in at least part of the misaligned portion of the through hole comprises depositing silicon dioxide in at least part of the misaligned portion of the through hole.

20. The method of any of Claims 12 to 19 wherein the step of forming the through hole further comprises the steps of:
forming a photo resist layer outwardly of the insulation layer;
patterning an opening in the photo resist layer substantially aligned with the lower conductor; and
etching the through hole in the insulation layer through the opening in the photo resist layer to expose the portion of the lower conductor.

21. The method of any of Claims 12 to 20 wherein the step of forming the misalignment insulation layer further comprises the steps of:
forming the misalignment insulation layer outwardly of a lower region of the through hole;
removing at least a portion of the misalignment insulation layer to expose at least a part of the portion of the lower conductor, the remaining portion of the misalignment insulation layer disposed at least part in the misaligned portion of the through hole.

22. An integrated circuit, comprising:
an insulation layer disposed outwardly of an under lower conductor
an upper conductor disposed outwardly of the insulation layer;
a lower conductor disposed in the insulation layer and spaced apart from the under lower conductor and the upper conductor;
a through hole formed in the insulation layer and substantially aligned over the lower conductor, the through hole extending from the upper conductor to the lower conductor and including a misaligned portion further extending toward the under lower conductor;
a misalignment insulation layer disposed at least in part in the misaligned portion between the lower conductor and the under lower conductor; and
an interconnect disposed in the through hole and connected to the lower conductor and the upper conductors.
